(19) Europäisches Patentamt
European Patent Office
Office européen des brevets

(11) EP 1 294 030 A2

## (12) EUROPEAN PATENT APPLICATION

(43) Date of publication:
19.03.2003 Bulletin 2003/12

(51) Int Cl.⁷: $H01L\ 41/08$, $H01L\ 41/187$

(21) Application number: 02256338.1

(22) Date of filing: 12.09.2002

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: **13.09.2001 JP 2001277889**

(71) Applicant: **NGK INSULATORS, LTD.**
**Nagoya-City, Aichi Prefecture 467-8530 (JP)**

(72) Inventors:
• **Yamaguchi, Hirofumi, IPD NGK Insulators, Ltd.**
**Nagoya-shi, Aichi-ken 467-8530 (JP)**
• **Kashiwaya, Toshikatsu,**
**IPD NGK Insulators, Ltd.**
**Nagoya-shi, Aichi-ken 467-8530 (JP)**
• **Yamamoto, Kazuhiro, IPD NGK Insulators, Ltd.**
**Nagoya-shi, Aichi-ken 467-8530 (JP)**
• **Takahashi, Masao, IPD NGK Insulators, Ltd.**
**Nagoya-shi, Aichi-ken 467-8530 (JP)**

(74) Representative: **Paget, Hugh Charles Edward et al**
**MEWBURN ELLIS**
**York House**
**23 Kingsway**
**London WC2B 6HP (GB)**

### (54) Piezoelectric/electrostrictive device

(57) A piezoelectric/electrostrictive device (10) comprises a piezoelectric/electrostrictive layer (24) and at least a pair of electrodes (26a, 26b) formed on the piezoelectric/electrostrictive layer (24), wherein the piezoelectric/electrostrictive layer (24) is composed of a material containing Mn in an amount corresponding to 0.1 to 0.5 % by weight as converted into an amount of $MnO_2$, in PZT (lead zirconate titanate), or a material containing Mn in an amount corresponding to 0.1 to 0.5 % by weight as converted into an amount of $MnO_2$, in a perovskite type piezoelectric/electrostrictive material based on $Pb(Mg_{1/3}Nb_{2/3})O_3\text{-}PbZrO_3\text{-}PbTiO_3$ which contains Pb and in which a part of Pb is substituted with Sr.

FIG. 1

**Description**

BACKGROUND OF THE INVENTION

Field of the Invention:

The present invention relates to a piezoelectric/electrostrictive device comprising a piezoelectric/electrostrictive layer and at least a pair of electrodes formed on the piezoelectric/electrostrictive layer, on a substrate having a thin-walled section and a thick-walled section formed around the thin-walled section. In particular, the present invention relates to a piezoelectric/electrostrictive device for converting electric energy into mechanical energy to be used, for example, for an ink-jet head and a display, or a piezoelectric/electrostrictive device for converting mechanical energy into electric energy.

Description of the Related Art:

A piezoelectric/electrostrictive device has been hitherto known as a device capable of controlling the minute displacement in sub-microns. Especially, the piezoelectric/electrostrictive device, which is constructed by stacking a piezoelectric/electrostrictive layer based on piezoelectric ceramics and an electrode layer for applying a voltage thereto, is preferably usable to control the minute displacement. Besides, such a piezoelectric/electrostrictive device has features including, for example, high electromechanical conversion efficiency, high speed response performance, durability, and small electric power consumption. The piezoelectric/electrostrictive device, which has the features as described above, is used, for example, as piezoelectric pressure sensors, probe movement mechanisms of scanning tunneling microscopes, straight guide mechanisms of ultra-high-precision machining machines, servo valves for hydraulic pressure control, heads of VTR machines, picture elements or images pixels for constructing flat panel type image display apparatuses, and heads for ink-jet printers.

When the piezoelectric/electrostrictive device is used as an actuator, then a positive or negative voltage is applied to one electrode, and the other electrode is grounded. In this situation, the piezoelectric/electrostrictive effect is brought about in the piezoelectric/electrostrictive layer, and the mechanical displacement is generated in the stacking direction.

It is assumed that the effective driving electric field, which is applied to the piezoelectric/electrostrictive layer, is increased in order to obtain a larger displacement amount. As for the range of the electric field, it has been tried to use a wide range ranging from the negative electric field to the positive electric field.

When the piezoelectric/electrostrictive device as described above is operated at room temperature, no problem arises. However, when the driving operation is performed for a long period of time in an environment in which the temperature is much lower than the Curie point but the temperature is higher than room temperature, it is feared that the displacement amount of the piezoelectric/electrostrictive device may be considerably decreased.

SUMMARY OF THE INVENTION

The present invention has been made taking the foregoing problem into consideration, an object of which is to provide a piezoelectric/electrostrictive device in which the decrease in displacement amount is successfully suppressed even when the driving operation is performed for a long period of time in an environment in which the temperature is higher than room temperature, and it is possible to improve the reliability and achieve a long period of service life.

According to the present invention, there is provided a piezoelectric/electrostrictive device including a main piezoelectric/electrostrictive device body comprising a piezoelectric/electrostrictive layer and at least a pair of electrodes formed on the piezoelectric/electrostrictive layer, on a substrate having a thin-walled section with a thick-walled section formed around the thin-walled section; wherein a displacement amount of the main piezoelectric/electrostrictive device body, which is obtained after continuous driving operation for 50 hours at a temperature of 70 °C, has a rate of decrease of not more than 15 % with respect to an initial displacement amount.

Accordingly, it is possible to suppress the decrease in displacement amount even when the driving operation is performed for a long period of time in an environment in which the temperature is higher than room temperature, and it is possible to improve the reliability and achieve a long period of service life.

In this arrangement, it is preferable that the piezoelectric/electrostrictive layer contains Mn in an amount corresponding to 0.1 to 0.5 % by weight as converted into an amount of $MnO_2$, in a perovskite type piezoelectric/electrostrictive material containing Pb.

It is preferable that the piezoelectric/electrostrictive device is driven to satisfy:

$$-0.8Ec \leq E1 \leq 0$$

$$1000 \leq E2 \leq 4000$$

wherein E1 (V/mm) and E2 (V/mm) represent a minimum electric field and a maximum electric field to be applied to the piezoelectric/electrostrictive layer during the continuous driving operation respectively, and Ec (V/mm) represents a coercive electric field.

The above and other objects, features, and advantages of the present invention will become more apparent from the following description when taken in conjunction with the accompanying drawings in which a preferred embodiment of the present invention is shown by way of illustrative example.

BRIEF DESCRIPTION OF THE DRAWINGS

FIG. 1 is a sectional view illustrating a piezoelectric/electrostrictive device according to an embodiment of the present invention;

FIG. 2 is a sectional view illustrating a first modified embodiment of the piezoelectric/electrostrictive device according to the embodiment of the present invention;

FIG. 3 is a plan view illustrating an electrode structure of the piezoelectric/electrostrictive device according to the first modified embodiment;

FIG. 4 is a sectional view illustrating a second modified embodiment of the piezoelectric/electrostrictive device according to the embodiment of the present invention;

FIG. 5 is a sectional view illustrating a third modified embodiment of the piezoelectric/electrostrictive device according to the embodiment of the present invention;

FIG. 6 is a sectional view illustrating a fourth modified embodiment of the piezoelectric/electrostrictive device according to the embodiment of the present invention;

FIG. 7A shows a hysteresis characteristic of an actuator element;

FIG. 7B shows a displacement characteristic obtained when the driving operation is performed by using a wide range ranging from the negative electric field to the positive electric field;

FIG. 7C shows a displacement characteristic obtained in a state in which the displacement amount is lowered;

FIGS. 8A and 8B are tables illustrating results of exemplary experiments (measurement of the rate of decrease in displacement amount of the actuator element after continuous driving operation for 50 hours at an environmental temperature of 70 °C);

FIG. 9 is an arrangement illustrating a state in which a displacement-transmitting member is placed or formed on the actuator element of the piezoelectric/electrostrictive device according to the embodiment of the present invention;

FIG. 10 is an arrangement illustrating, with partial omission, an example in which the piezoelectric/electrostrictive device according to the embodiment of the present invention is applied to a display; and

FIG. 11 is an arrangement illustrating, with partial omission, another example in which the piezoelectric/electrostrictive device according to the embodiment of the present invention is applied to a display.

DESCRIPTION OF THE PREFERRED EMBODIMENTS

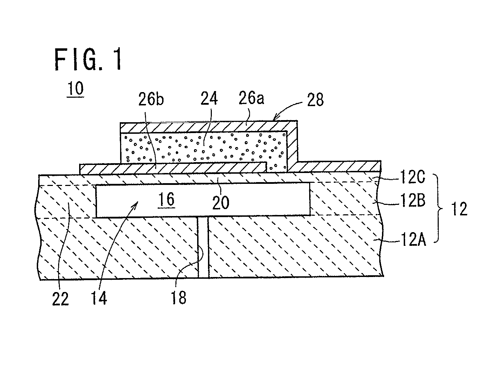

Illustrative embodiments of the piezoelectric/electrostrictive device according to the present invention will be explained below with reference to FIGS. 1 to 11.

As shown in FIG. 1, a piezoelectric/electrostrictive device 10 according to an embodiment of the present invention comprises an actuator substrate 12 which is composed of, for example, ceramics, and an actuator element 14 which performs the displacement action in accordance with application of the voltage.

Hollow spaces 16 for forming respective vibrating sections as described later on are provided in the actuator substrate 12 at positions corresponding to the portions at which the respective actuator elements 14 are to be formed. The respective hollow spaces 16 communicate with the through-holes 18 each of which has a small diameter and which are provided at a lowermost layer of the actuator substrate 12.

The portion of the actuator substrate 12, at which the hollow space 16 is formed, is thin-walled. The other portion of the actuator substrate 12 is thick-walled. The thin-walled portion has a structure which tends to undergo vibration in response to the external stress, and it functions as a vibrating section 20. The portion other than the hollow space 16 is thick-walled, and it functions as a fixed section 22 for supporting the vibrating section 20.

That is, the actuator substrate 12 has a stacked structure comprising a substrate layer 12A as the lowermost layer, a spacer layer 12B as an intermediate layer, and a thin plate layer 12C as an uppermost layer. The actuator substrate 12 can be recognized to have an integrated structure including the hollow spaces 16 formed at the positions in the spacer layer 12B corresponding to the actuator elements 14. The substrate layer 12A functions as a substrate for reinforcement, as well as it functions as a substrate for wiring. The actuator substrate 12 may be formed as follows. That is, the respective layers may be simultaneously sintered and integrated into one unit. Alternatively, the respective layers may be laminated and integrated into one unit while successively sintering the respective layers. Further alternatively, the respective layers may be individually sintered, and then they may be laminated and integrated into one unit.

On the other hand, each of the actuator elements 14 comprises the vibrating section 20 and the fixed section 22, as well as a main actuator element 28 which is composed of a piezoelectric/electrostrictive layer 24 directly formed on the vibrating section 20, and a pair of electrodes (an upper electrode 26a and a lower electrode 26b) formed on an upper surface and a lower surface of the piezoelectric/electrostrictive layer 24.

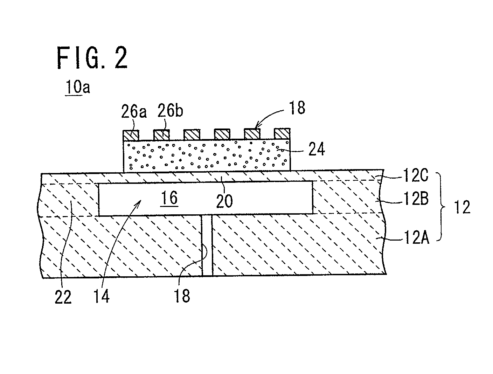

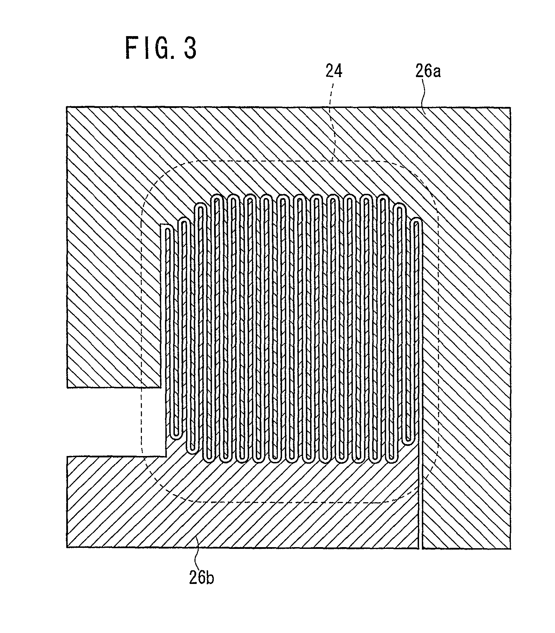

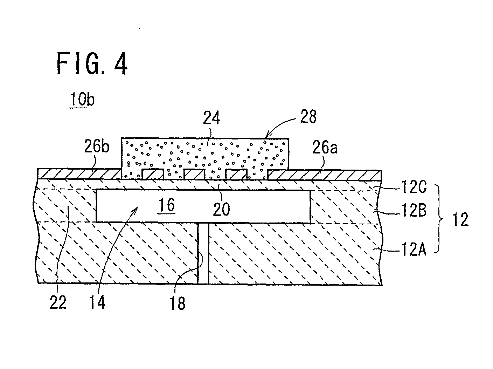

The pair of electrodes may be embodied as follows other then the upper electrode 26a and the lower electrode 26b described above. That is, as in a piezoelectric/electrostrictive device 10a according to a first modified embodiment shown in FIG. 2, a pair of comb-shaped electrodes 26a, 26b as shown, for example, in FIG. 3 may be formed on the upper surface of the piezoelectric/electrostrictive layer 24. Alternatively, as in a piezoelectric/electrostrictive device 10b according to a second modified embodiment shown in FIG. 4, a pair of electrodes 26a, 26b may be formed between the piezoelectric/electrostrictive layer 24 and the vibrating section 20.

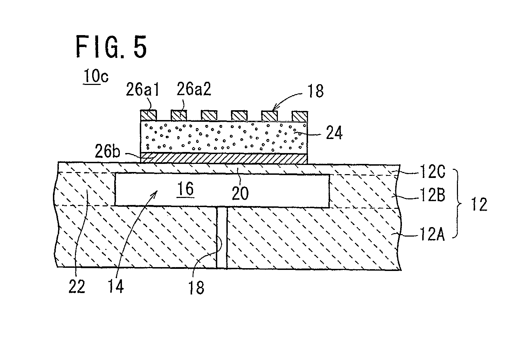

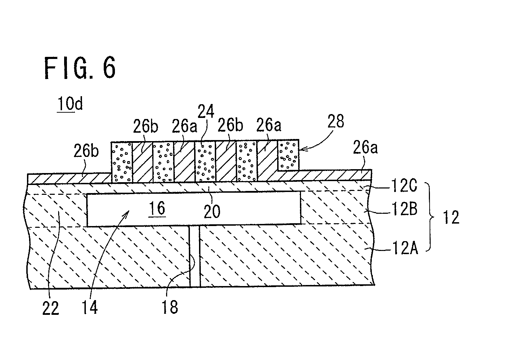

In another arrangement, as in a piezoelectric/electrostrictive device 10c according to a third modified embodiment shown in FIG. 5, the upper electrode 24a may be formed with a plurality of strip-shaped electrodes 26a1, 26a2, and the lower electrode 26b may be formed to have a form of single flat film. Alternatively, as in a piezoelectric/electrostrictive device 10d according to a fourth modified embodiment shown in FIG. 6, a pair of comb-shaped electrodes 26a, 26b may be embedded in the piezoelectric/electrostrictive layer 24. In this arrangement, the pair of electrodes 26a, 26b are formed that lower surfaces of the pair of electrodes 26a, 26b contact the vibrating section 20.

The structures shown in FIGS. 2 to 5 are advantageous in that the electric power consumption can be suppressed to be low. The structure shown in FIG. 6 is advantageous to generate large displacement, because this structure can effectively utilize the inverse piezoelectric effect in the electric field direction in which the strain and the generated force are large.

Next, explanation will be made for the respective constitutive members of the piezoelectric/electrostrictive device 10 according to the embodiment of the present invention, especially for the selection of the material or the like for the respective constitutive members.

At first, it is preferable that the vibrating section 20 is composed of a highly heat-resistant material, for the following reason. That is, when the main actuator element 28 is stacked on the vibrating section 20 without using any material such as an organic adhesive which may deteriorate the characteristics, the heat treatment is performed in some cases when at least the piezoelectric/electrostrictive layer 24 is formed. The vibrating section 20 is preferably composed of a highly heat-resistant material in order that the vibrating section 20 is not deteriorated in quality during the process as described above.

It is preferable that the vibrating section 20 is composed of an electric insulating material in order to electrically separate the wiring connected to the upper electrode 26a formed on the actuator substrate 12, from the wiring connected to the lower electrode 26b.

Therefore, the vibrating section 20 may be composed of a material such as a highly heat-resistant metal and a porcelain enamel produced by coating a surface of such a metal with a ceramic material such as glass. However, the vibrating section 20 is optimally composed of ceramics.

The vibrating section 20 may be composed of ceramics such as stabilized zirconium oxide, aluminum oxide, magnesium oxide, titanium oxide, spinel, mullite, aluminum nitride, silicon nitride, glass, or mixtures thereof. Stabilized zirconium oxide is especially preferred because of, for example, high mechanical strength obtained even if the thickness of the vibrating section 20 is thin, high toughness, and small chemical reactivity with the piezoelectric/electrostrictive layer 24 and the pair of electrodes 26a, 26b. The term "stabilized zirconium oxide" includes fully stabilized zirconium oxide and partially stabilized zirconium oxide. Stabilized zirconium oxide has a crystal structure such as cubic crystal, and hence it does not cause phase transition.

On the other hand, zirconium oxide causes phase transition between monoclinic crystal and tetragonal crystal at about 1000 °C. Cracks appear during the phase transition in some cases. Stabilized zirconium oxide contains 1 to 30 mole % of a stabilizer such as calcium oxide, magnesium oxide, yttrium oxide, scandium oxide, ytterbium oxide, cerium oxide, and oxides of rare earth metals. In order to enhance the mechanical strength of the vibrating section 20, the stabilizer preferably contains yttrium oxide. In this composition, yttrium oxide is contained preferably in an amount of 1.5 to 6 mole %, and more preferably 2 to 4 mole %. It is much more preferable that aluminum oxide is further contained in an amount of 0.1 to 5 mole %.

The crystal phase may be, for example, a mixed phase of cubic crystal and monoclinic crystal, a mixed phase of tetragonal crystal and monoclinic crystal, and a mixed phase of cubic crystal, tetragonal crystal and monoclinic crystal. However, among them, most preferred are those having a principal crystal phase composed of tetragonal crystal or a mixed phase of tetragonal crystal and cubic crystal, from viewpoints of strength, toughness, and durability.

When the vibrating section 20 is composed of ceramics, a large number of crystal grains construct the vibrating section 20. In order to increase the mechanical strength of the vibrating section 20, the crystal grains preferably have an average grain diameter of 0.05 to 2 $\mu$m, and more preferably 0.1 to 1 $\mu$m.

The fixed section 22 is preferably composed of ceramics. The fixed section 22 may be composed of the same ceramic material as that used for the vibrating section 20, or the fixed section 22 may be composed of a ceramic material different from that used for the vibrating section 20. The fixed section 22 may be composed of ceramics material such as stabilized zirconium oxide, aluminum oxide, magnesium oxide, titanium oxide, spinel, mullite, aluminum nitride, silicon nitride, glass, or mixtures thereof, in the same manner as the material for the vibrating section 20.

Especially, the actuator substrate 12 used in the ceramic device include materials such as materials containing a major component of zirconium oxide, materials containing a major component of aluminum oxide, or materials containing a major component of a mixture thereof. The materials containing a major component of zirconium oxide are more preferable particularly.

Clay or the like is added as a sintering aid in some cases. However, it is necessary to control components of the sintering aid in order not to contain an excessive amount of materials which are liable to form glass such as silicon oxide and boron oxide for the following reason. That is, although the materials are advantageous to join the actuator substrate 12 to the piezoelectric/electrostrictive layer 24, the materials facilitate the reaction between the actuator substrate 12 and the piezoelectric/electrostrictive layer 24, making it difficult to maintain a predetermined composition of the piezoelectric/electrostrictive layer 24. As a result, the materials make a cause to deteriorate the device characteristics.

That is, it is preferable that silicon oxide or the like in the actuator substrate 12 is restricted to have a weight ratio of not more than 3 %, and more preferably not more than 1 %. The term "major component" herein refers to the component which exists in a proportion of not less than 50 % in weight ratio.

The upper electrode 26a and the lower electrode 26b formed on the upper surface and the lower surface of the piezoelectric/electrostrictive layer 24, the pair of electrodes 26a, 26b formed on the upper surface of the piezoelectric/electrostrictive layer 24 as shown in FIG. 2, the pair of electrodes 26a, 26b formed between the piezoelectric/electrostrictive layer 24 and the vibrating section 20 as shown in FIG. 4, the upper electrode 26a and the lower electrode 26b in which the upper electrode 26a is formed with the plurality of strip-shaped electrodes 26a1, 26a2 and the lower electrode 26b is formed to have the form of single flat film as shown in FIG. 5, and the pair of electrodes 26a, 26b formed by being embedded in the piezoelectric/electrostrictive layer 24 as shown in FIG. 6 are allowed to have an appropriate thickness depending on the application. However, the thickness is preferably 0.01 to 50 µm, and more preferably 0.1 to 5 µm.

Each of the lower electrode 26b shown in FIG. 1, the pair of electrodes 26a, 26b shown in FIG. 4, the lower electrode 26b shown in FIG. 5, and the pair of electrodes 26a, 26b shown in FIG. 6 is composed of the electrode material which contains a simple substance of an element belonging to the platinum group, an alloy of the simple substance of the element belonging to the platinum group and gold and/or silver, an alloy of an element belonging to the platinum group, or an alloy of the alloy of the element belonging to the platinum group and gold and/or silver. Preferably, the electrode material is a material containing a major component of platinum.

The upper electrode 26a is preferably composed of a conductive metal which is solid at room temperature. The metal includes, for example, metal simple substances or alloys containing, for example, aluminum, titanium, chromium, iron, cobalt, nickel, copper, zinc, niobium, molybdenum, ruthenium, rhodium, silver, stannum, tantalum, tungsten, iridium, platinum, gold, and lead. It is needless to say that these elements may be contained in an arbitrary combination.

A variety of known film formation methods are usable to form the lower electrode 26b and the upper electrode 26a. Specifically, selection is appropriately made for the thin film formation method such as the ion beam, the sputtering, the vacuum evaporation, CVD, the ion plating, and the plating, and the thick film formation method such as the screen printing, the spray, and the dipping. The sputtering method and the screen printing method are selected especially preferably. The heat treatment is performed, if necessary.

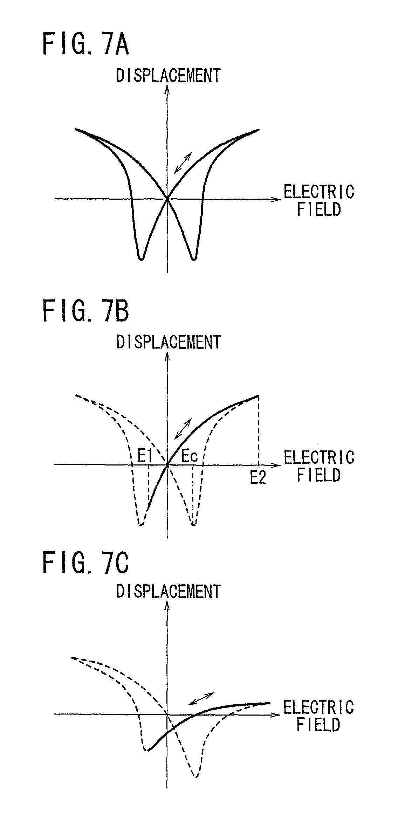

In the case of the ordinary piezoelectric/electrostrictive device, the displacement pattern of the actuator element 14, which is obtained when the electric field is applied to the piezoelectric/electrostrictive layer 24, has the hysteresis characteristic as shown in FIG. 7A. This indicates the fact that the displacement appears equivalently in the piezoelectric/electrostrictive layer 24 of the actuator element 14 even when the polarity of the electric field differs, provided that the absolute value of the magnitude of the electric field is identical.

It is conceived that the effective driving electric field, which is applied to the piezoelectric/electrostrictive layer 24, is increased in order to obtain a larger displacement amount in the actuator element 14. For example, as shown in FIG. 7B, it is assumed that the driving operation is performed to satisfy:

$$-0.8Ec \leq E1 \leq 0$$

$$1000 \leq E2 \leq 4000$$

provided that E1 (V/mm) and E2 (V/mm) represent the minimum electric field and the maximum electric field to be applied to the piezoelectric/electrostrictive layer 24 respectively, and Ec (V/mm) represents the coercive electric field.

However, if the driving operation is repeatedly performed for a long period of time, then the displacement pattern of the actuator element 14 with respect to the electric field is changed as shown in FIG. 7C, and the decrease in displacement amount of the actuator element 14 appears. Especially, when the driving operation is performed for a long period of time in an environment (for example, at 70 °C) in which the temperature is much lower than the Curie point but the temperature is higher than room temperature, the decrease in displacement amount of the actuator element 14 conspicuously appears.

In view of the above, the piezoelectric/electrostrictive device 10 according to the embodiment of the present invention is constructed so that the decrease in displacement amount is successfully suppressed, even when the driving operation is performed for a long period of time in an environment in which the temperature is higher than room temperature.

That is, in the piezoelectric/electrostrictive device 10 according to the embodiment of the present invention, the displacement amount of the actuator element 14, which is obtained after the continuous driving operation for 50 hours at a temperature of 70 °C, has the rate of decrease of not more than 15 % with respect to the initial displacement amount.

In order to realize this feature, in the embodiment of the present invention, the piezoelectric/electrostrictive layer 24 is composed of a material which contains Mn in an amount corresponding to 0.1 to 0.5 % by weight as converted into an amount of $MnO_2$, in a perovskite type piezoelectric/electrostrictive material containing Pb.

Specifically, the piezoelectric/electrostrictive layer 24 is composed of a material containing Mn in an amount corresponding to 0.1 to 0.5 % by weight as converted into an amount of $MnO_2$, in PZT (lead zirconate titanate), or a material containing Mn in an amount corresponding to 0.1 to 0.5 % by weight as converted into an amount of $MnO_2$, in a perovskite type piezoelectric/electrostrictive material based on $Pb(Mg_{1/3}Nb_{2/3})O_3$-$PbZrO_3$-$PbTiO_3$. In the material as described above, a part of Pb may be substituted, for example, with Sr, Ca, Ba, or La.

To prepare the piezoelectric/electrostrictive material as described above, the oxide-mixing method is useful, for example. For example, the piezoelectric/electrostrictive material can be prepared by means of a method in which raw powder materials of, for example, PbO, $SrCO_3$, $MgCO_3$, $Nb_2O_5$, $ZrO_2$, $TiO_2$, and $MnO_2$ are weighed to give a predetermined composition, followed by performing mixing, preliminary sintering, and pulverization. To prepare the piezoelectric/electrostrictive material, the other methods include, for example, the coprecipitation method and the alkoxide method.

The method for forming the piezoelectric/electrostrictive layer 24 on the vibrating section 20 may be various types of the thick film formation method such as the screen printing method, the dipping method, the application method, and the electrophoresis method, and various types of the thin film formation method such as the ion beam method, the sputtering method, the vacuum evaporation method, the ion plating method, the chemical vapor deposition method (CVD), and the plating.

In this embodiment, when the piezoelectric/electrostrictive layer 24 is formed on the vibrating section 20, the thick film formation method is preferably adopted, which is based on, for example, the screen printing method, the dipping method, the application method, and the electrophoresis method, for the following reason.

That is, in the techniques described above, the piezoelectric/electrostrictive layer 24 can be formed by using, for example, paste, slurry, suspension, emulsion, or sol containing a major component of piezoelectric ceramic particles having an average grain size of 0.01 to 5 $\mu$m, preferably 0.05 to 3 $\mu$m, in which it is possible to obtain good piezoelectric operation characteristics.

Especially, the electrophoresis method makes it possible to form the film having a high density and a high shape accuracy, and the electrophoresis method further has the features as described in technical literatures such as "Preparation of Electronic Materials by Electrophoretic Deposition" written by Kazuo ANZAI, DENKI KAGAKU 53, No. 1 (1985), pp. 63-68 and "Proceedings of First Symposium on Higher-Order Ceramic Formation Method Based on Electrophoresis 1998, pp. 5-6 and pp. 23-24". Therefore, the technique may be appropriately selected and used considering, for example, the required accuracy and the reliability.

It is preferable that the thickness of the vibrating section 20 has a dimension identical to that of the thickness of the piezoelectric/electrostrictive layer 24, for the following reason. That is, if the thickness of the vibrating section 20 is extremely thicker than the thickness of the piezoelectric/electrostrictive layer 24 (if the former is different from the latter by not less than one figure), when the piezoelectric/electrostrictive layer 24 makes shrinkage upon the sintering, then the vibrating section 20 behaves to inhibit the shrinkage. For this reason, the stress at the boundary surface between the piezoelectric/electrostrictive layer 24 and the actuator substrate 12 is increased, and consequently they are easily peeled off from each other. On the contrary, when the dimension of the thickness is in an identical degree between the both, it is easy for the actuator substrate 12 (vibrating section 20) to follow the shrinkage of the piezoelectric/electrostrictive layer 24 upon the sintering. Accordingly, such dimension of the thickness is preferred to achieve the integration. Specifically, the vibrating section 20 preferably has a thickness of 1 to 100 $\mu$m, more preferably 3 to 50 $\mu$m, and much more preferably 5 to 20 $\mu$m. On the other hand, the piezoelectric/electrostrictive layer 24 preferably has a thickness of 5 to 100 $\mu$m, more preferably 5 to 50 $\mu$m, and much more preferably 5 to 30 $\mu$m.

The piezoelectric/electrostrictive layer 24 formed as described above is heat-treated, if necessary, and the piezoelectric/electrostrictive layer 24 is integrated with the lower electrode 26b formed on the actuator substrate 12.

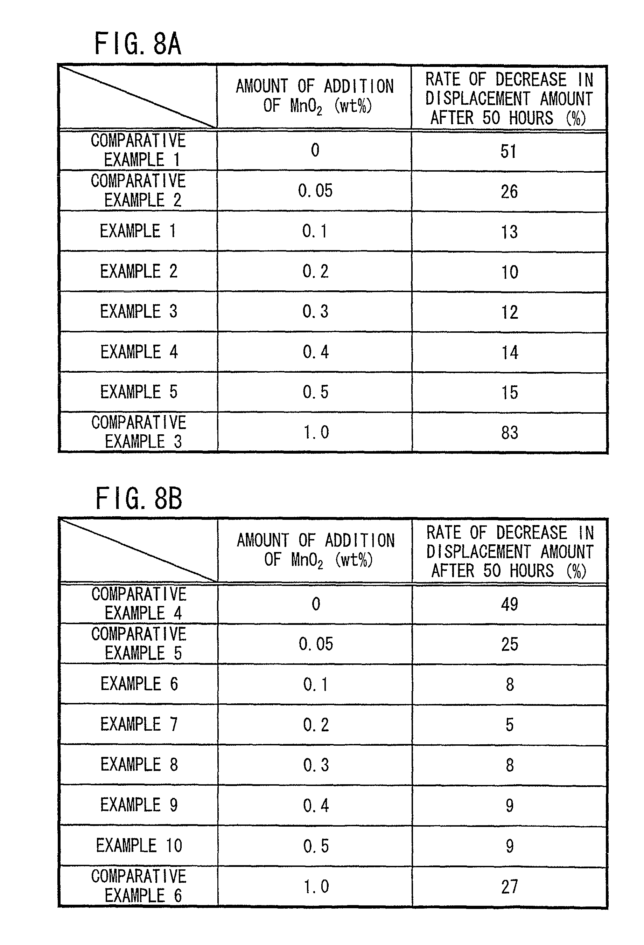

Certain exemplary experiments will now be described. In Comparative Examples 1 to 6 and Examples 1 to 10, the driving electric field was applied respectively to measure the initial displacement amount obtained thereby and the behavior of change of the displacement amount after the continuous driving operation for 50 hours. Results of the measurement are shown in FIGS. 8A and 8B.

The condition of the continuous driving operation was as follows. That is, the piezoelectric/electrostrictive layer 24 had a size of about 20 μm, for which the waveform of the driving voltage was pulse-shaped. The minimum applied voltage was -10 V, and the maximum applied voltage was 55 V. The duty ratio (time of application of -10 V/time of application of 55 V) of the voltage waveform was 1/9, the frequency was 60 Hz, and the environmental temperature was 70 °C. The displacement amount of each of the piezoelectric/electrostrictive devices 10 was measured by measuring the displacement amount obtained when 60 V was applied at room temperature.

In Comparative Examples 1 to 3 and Examples 1 to 5, a perovskite type piezoelectric/electrostrictive material based on PZT (lead zirconate titanate) was used for the material for constructing the piezoelectric/electrostrictive layer 24. As shown in FIG. 8A, Comparative Example 1 is illustrative of a case in which $MnO_2$ was not added to the constitutive materials for the piezoelectric/electrostrictive layer 24. Comparative Example 2 is illustrative of a case in which $MnO_2$ was added in an amount of 0.05 % by weight to the constitutive materials for the piezoelectric/electrostrictive layer 24. Comparative Example 3 is illustrative of a case in which $MnO_2$ was added in an amount of 1.0 % by weight to the constitutive materials for the piezoelectric/electrostrictive layer 24.

Examples 1 to 5 are illustrative of cases in which $MnO_2$ was added to the constitutive materials for the piezoelectric/electrostrictive layer 24 in amounts of 0.1 % by weight, 0.2 % by weight, 0.3 % by weight, 0.4 % by weight, and 0.5 % by weight respectively.

On the other hand, in Comparative Examples 4 to 6 and Examples 6 to 10, a perovskite type piezoelectric/electrostrictive material based on $Pb(Mg_{1/3}Nb_{2/3})O_3$-$PbZrO_3$-$PbTiO_3$ in which a part of Pb was substituted with Sr was used for the material for constructing the piezoelectric/electrostrictive layer 24. As shown in FIG. 8B, the amounts of addition of $MnO_2$ were the same as those in Comparative Examples 1 to 3 and Examples 1 to 5 described above.

As appreciated from the results shown in FIG. 8A, when the perovskite type piezoelectric/electrostrictive material based on PZT (lead zirconate titanate) is used for the material for constructing the piezoelectric/electrostrictive layer 24, the rate of decrease in the displacement amount of the actuator element 14 after the continuous driving operation for 50 hours at the environmental temperature of 70 °C with respect to the initial displacement amount can be suppressed to be not more than 15 %, provided that the amount of addition of $MnO_2$ is within the range of 0.1 to 0.5 % by weight.

Further, according to the results shown in FIG. 8B, the following fact is appreciated. That is, when the perovskite type piezoelectric/electrostrictive material based on $Pb(Mg_{1/3}Nb_{2/3})O_3$-$PbZrO_3$-$PbTiO_3$ in which a part of Pb is substituted with Sr is used for the material for constructing the piezoelectric/electrostrictive layer 24, the rate of decrease in the displacement amount of the actuator element 14 after the continuous driving operation for 50 hours at the environmental temperature of 70 °C with respect to the initial displacement amount can be suppressed to be not more than 9 %, provided that the amount of addition of $MnO_2$ is within the range of 0.1 to 0.5 % by weight. The rate of decrease in the displacement amount is small as compared with the case in which the perovskite type piezoelectric/electrostrictive material based on PZT (lead zirconate titanate) is used for the material for constructing the piezoelectric/electrostrictive layer 24.

As described above, in the piezoelectric/electrostrictive device 10 according to the embodiment of the present invention, the rate of decrease in the displacement amount of the actuator element 14 after the continuous driving operation for 50 hours at the temperature of 70 °C with respect to the initial displacement amount can be suppressed to be not more than 15 %. Even when the driving operation is performed for a long period of time in an environment in which the temperature is higher than room temperature, then it is possible to suppress the decrease in displacement amount, and it is possible to improve the reliability and achieve a long period of service life.

Further, in the embodiment of the present invention, the piezoelectric/electrostrictive layer 24 contains Mn in the amount corresponding to 0.1 to 0.5 % by weight as converted into the amount of $MnO_2$ in the perovskite type piezoelectric/electrostrictive material containing Pb. Therefore, even when the effective driving electric field is allowed to be within the wide range ranging from the negative electric field to the positive electric field as shown in FIG. 7B to perform the driving operation for a long period, then the decrease in displacement amount as shown in FIG. 7C is suppressed, and the displacement characteristic shown in FIG. 7B can be maintained approximately as it is.

Especially, the piezoelectric/electrostrictive layer 24 is composed of the material containing Mn in the amount corresponding to 0.1 to 0.5 % by weight as converted into the amount of $MnO_2$ in PZT (lead zirconate titanate), or the material containing Mn in the amount corresponding to 0.1 to 0.5 % by weight as converted into the amount of $MnO_2$ in the perovskite type piezoelectric/electrostrictive material based on $Pb(Mg_{1/3}Nb_{2/3})O_3$-$PbZrO_3$-$PbTiO_3$ which contains Pb and in which a part of Pb is substituted with Sr. Therefore, the rate of decrease in the displacement amount of the actuator element 14 with respect to the initial displacement amount can be suppressed to be not more than 15 %, even when the driving operation is performed for a long period of time in an environment (for example, at 70 °C) in which the temperature is much lower than the Curie point but the temperature is higher than room temperature.

Therefore, in the embodiment of the present invention, it is successfully unnecessary to provide any special circuit for adjusting the driving electric field depending on the decrease in displacement amount. Further, it is possible to improve the reliability and achieve the long service life or durability.

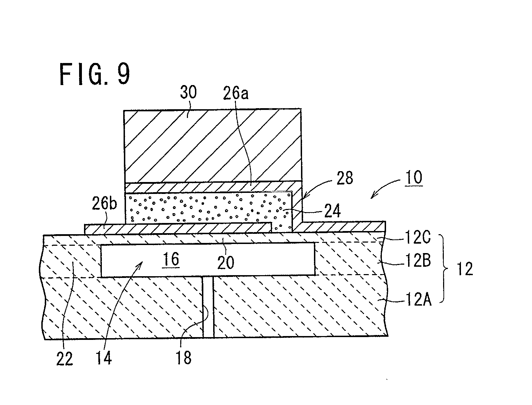

According to the fact as described above, the piezoelectric/electrostrictive device 10 according to the embodiment of the present invention may be used, for example, in a form as shown in FIG. 9. That is, a displacement-transmitting member 30, which is provided to transmit the displacement of the actuator element 14, for example, in the upward direction, is placed or formed on the upper portion of the actuator element 14. Accordingly, application may be made to a variety of fields. That is, various ones are usable for the displacement-transmitting member 30 depending on the embodiments of the piezoelectric/electrostrictive device 10 according to the embodiment of the present invention.

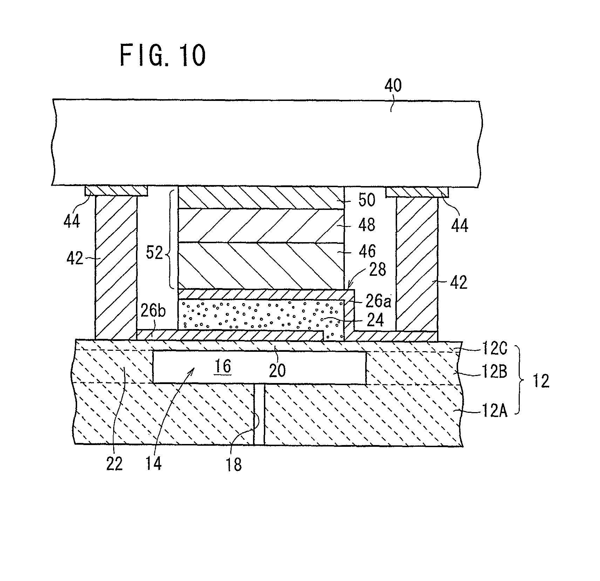

For example, when the piezoelectric/electrostrictive device 10 is used for the picture elements (image pixels) of a display, the following structure may be adopted as shown in FIG. 10. That is, an optical waveguide plate 40 is arranged opposingly to the actuator substrate 12. Further, a plurality of crosspieces 42 are formed between the optical waveguide plate 40 and the actuator substrate 12. The actuator elements 14 are arranged corresponding to the respective picture elements. FIG. 10 is illustrative of a case in which light-shielding layers 44 are formed between the optical waveguide plate 40 and the crosspieces 42 respectively.

A picture element assembly 52, which is composed of a stack based on resin including, for example, a white scattering element 46, a color layer 48, and a transparent layer 50, is formed on each of the actuator elements 14. The picture element assembly 52 makes contact and separation with respect to the optical waveguide plate 40 in accordance with the displacement action of the actuator element 14.

Light is introduced from an unillustrated light source into the optical waveguide plate 40. When the end surface of the picture element assembly 52 makes contact with the optical waveguide plate 40 in accordance with the displacement action of the actuator element 14, light is emitted from a position corresponding to the picture element assembly 52 of the front surface (display surface) of the optical waveguide plate 40. In other words, an image is displayed on the display surface by controlling the presence or absence of light emission (leakage light) at the display surface in accordance with the presence or absence of the contact of the picture element assembly 52 with the optical waveguide plate 40.

For example, in the structure as shown in FIGS. 9 and 10, the thickness of the thin plate layer 12C is usually not more than 50 $\mu$m and preferably about 3 to 20 $\mu$m in order to greatly displace the actuator element 14.

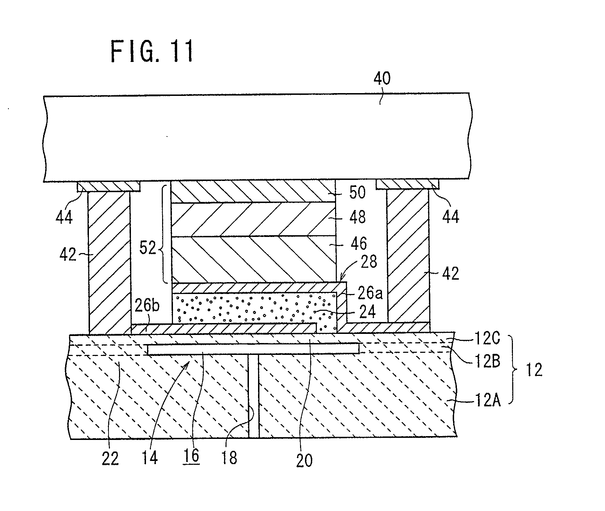

It is enough that the spacer layer 12B exists to constitute the hollow space 16 in the actuator substrate 12, and its thickness is not specifically limited. However, on the other hand, the thickness may be determined depending on the purpose of use of the hollow space 16. Especially, the thickness is not more than a thickness which is necessary for the actuator element 14 to function. For example, as shown in FIG. 11, it is preferable that the spacer layer 12B is constructed in a thin state. That is, it is preferable that the thickness of the spacer layer 12B is equivalent to the magnitude of the displacement of the actuator element 14 to be used.

Owing to the arrangement as described above, the following effect is obtained. That is, the flexion of the thin-walled portion (portion of the vibrating section 20) is restricted by the substrate layer 12A which is disposed closely in the direction of flexion. It is possible to prevent the thin-walled portion from destruction which would be otherwise caused by unintentional application of any external force. It is also possible to stabilize the displacement of the actuator element 14 to have a specified value by utilizing the effect to restrict the flexion brought about by the substrate layer 12A.

When the spacer layer 12B is made thin, then the thickness of the actuator substrate 12 itself is decreased, and it is possible to decrease the flexural rigidity. Accordingly, for example, when the actuator substrate 12 is bonded and fixed to another member, then the warpage or the like of the subject (in this case, the actuator substrate 12) is effectively reformed with respect to the object (for example, the optical waveguide plate 40), and it is possible to improve the reliability of the bonding and the fixation.

Additionally, the actuator substrate 12 is constructed to be thin as a whole, and hence it is possible to reduce the amount of use of raw materials when the actuator substrate 12 is produced. This structure is also advantageous in view of the production cost. Therefore, in particular, it is preferable that the thickness of the spacer layer 12B is 3 to 50 $\mu$m. Especially, it is preferable that the thickness of the spacer layer 12B is 3 to 20 $\mu$m.

On the other hand, the thickness of the substrate layer 12A is generally not less than 50 $\mu$m and preferably about 80 to 300 $\mu$m in order to reinforce the entire actuator substrate 12, because the spacer layer 12B is constructed to be thin as described above.

In the embodiment described above, the perovskite type piezoelectric/electrostrictive material contains $Pb(Mg_{1/3}Nb_{2/3})O_3$-$PbZrO_3$-$PbTiO_3$ as the piezoelectric/electrostrictive material. Alternatively, it is also allowable to use a composite perovskite type piezoelectric/electrostrictive material such as $Pb(Ni_{1/3}Nb_{2/3})O_3$, $Pb(Zn_{1/3}Nb_{2/3})O_3$, $Pb(Yb_{1/2}Nb_{1/2})O_3$, and $Pb(Sc_{1/2}Ta_{1/2})O_3$, in place of $Pb(Mg_{1/3}Nb_{2/3})O_3$ described above. Further, the perovskite type piezoelectric/electrostrictive material containing Pb may be substituted and/or added, for example, with La and/or Ni in order to improve, for example, the characteristics and the sintering performance.

It is a matter of course that the piezoelectric/electrostrictive device according to the present invention is not limited to the embodiments described above, which may be embodied in other various forms without deviating from the gist or essential characteristics of the present invention.

**Claims**

1. A piezoelectric/electrostrictive device including a main piezoelectric/electrostrictive device body (28) comprising a piezoelectric/electrostrictive layer (24) and at least a pair of electrodes (26a, 26b) formed on said piezoelectric/electrostrictive layer (24), on a substrate (12) having a thin-walled section (20) and a thick-walled section (22) formed around said thin-walled section (20),

   wherein a displacement amount of said main piezoelectric/electrostrictive device body (28), which is obtained after continuous driving operation for 50 hours at a temperature of 70 °C, is decreased by not more than 15 % with respect to an initial displacement amount of said main piezoelectric/electrostrictive device body (28).

2. The piezoelectric/electrostrictive device according to claim 1, wherein said piezoelectric/electrostrictive layer (24) is made with a perovskite piezoelectric/electrostrictive material containing Pb, and wherein said perovskite piezoelectric/electrostrictive material contains $MnO_2$ in an amount of 0.1 to 0.5 % by weight.

3. The piezoelectric/electrostrictive device according to claim 1 or 2, wherein said piezoelectric/electrostrictive device is driven to satisfy:

$$-0.8Ec \leq E1 \leq 0$$

$$1000 \leq E2 \leq 4000$$

   wherein E1 (V/mm) and E2 (V/mm) represent a minimum electric field and a maximum electric field to be applied to said piezoelectric/electrostrictive layer (24) during said continuous driving operation respectively, and Ec (V/mm) represents a coercive electric field.

## FIG. 1

FIG. 2

10a

26a  26b                    18

                              24

12C
16    20                     12B   } 12

                              12A

22   14      18

FIG. 3

24    26a

26b

FIG. 4

# FIG. 5

## FIG. 6

10d

26b  26a  24  26b  26a      28

26b                              26a

12C
16   20                          12B    } 12
12A

22   14      18

FIG. 7A

DISPLACEMENT

ELECTRIC
FIELD

FIG. 7B

DISPLACEMENT

E1  Ec

E2

ELECTRIC
FIELD

FIG. 7C

DISPLACEMENT

ELECTRIC
FIELD

## FIG. 8A

| | AMOUNT OF ADDITION OF $MnO_2$ (wt%) | RATE OF DECREASE IN DISPLACEMENT AMOUNT AFTER 50 HOURS (%) |
|---|---|---|
| COMPARATIVE EXAMPLE 1 | 0 | 51 |
| COMPARATIVE EXAMPLE 2 | 0.05 | 26 |
| EXAMPLE 1 | 0.1 | 13 |
| EXAMPLE 2 | 0.2 | 10 |
| EXAMPLE 3 | 0.3 | 12 |
| EXAMPLE 4 | 0.4 | 14 |
| EXAMPLE 5 | 0.5 | 15 |
| COMPARATIVE EXAMPLE 3 | 1.0 | 83 |

## FIG. 8B

| | AMOUNT OF ADDITION OF $MnO_2$ (wt%) | RATE OF DECREASE IN DISPLACEMENT AMOUNT AFTER 50 HOURS (%) |
|---|---|---|
| COMPARATIVE EXAMPLE 4 | 0 | 49 |
| COMPARATIVE EXAMPLE 5 | 0.05 | 25 |
| EXAMPLE 6 | 0.1 | 8 |
| EXAMPLE 7 | 0.2 | 5 |
| EXAMPLE 8 | 0.3 | 8 |
| EXAMPLE 9 | 0.4 | 9 |
| EXAMPLE 10 | 0.5 | 9 |
| COMPARATIVE EXAMPLE 6 | 1.0 | 27 |

FIG. 9

FIG. 10

FIG. 11